Europäisches Patentamt

European Patent Office

Office européen des brevets

(19)

(11) EP 0 420 322 B1

(12) **FASCICULE DE BREVET EUROPEEN**

(45) Date de publication et mention
de la délivrance du brevet:
**17.04.1996 Bulletin 1996/16**

(51) Int Cl.6: **H01L 21/82, H01L 21/331**

(21) Numéro de dépôt: **90202453.8**

(22) Date de dépôt: **17.09.1990**

(54) **Procédé de réalisation d'un circuit semiconducteur intégré incluant un transistor bipolaire à hétérojonction et/ou des résistances enterrées**

Verfahren zur Herstellung einer halbleiterintegrierten Schaltung umfassend einen Heteroübergang-Bipolartransistor und/oder einen vergrabenen Widerstand

Process for manufacturing a semiconductor integrated circuit including a heterojunction bipolar transistor and/or buried resistors

(84) Etats contractants désignés:
**DE FR GB IT**

(30) Priorité: **21.09.1989 FR 8912405**

(43) Date de publication de la demande:
**03.04.1991 Bulletin 1991/14**

(73) Titulaires:
• **LABORATOIRES D'ELECTRONIQUE PHILIPS S.A.S.**
**F-94450 Limeil-Brévannes (FR)**
Etats contractants désignés:
**FR**
• **Philips Electronics N.V.**
**NL-5621 BA Eindhoven (NL)**
Etats contractants désignés:
**DE GB IT**

(72) Inventeur: **Villalon, Claudine,**
**Société Civile S.P.I.D.**
**F-75008 Paris (FR)**

(74) Mandataire: **Landousy, Christian et al**
**Société Civile S.P.I.D.**
**156, Boulevard Haussmann**
**F-75008 Paris (FR)**

(56) Documents cités:
**EP-A- 0 188 897**

• **IEEE ELECTRON DEVICE LETTERS, vol. 10, no. 7, juillet 1989, pages 313-315, IEEE, New York, US; D. BARKER et al.: "Extremely high peak specific transconductance AlGaAs/GaAs heterojunction bipolar transistors"**
• **GALLIUM ARSENIDE AND RELATED COMPOUNDS 1985, PROCEEDINGS OF THE 12TH INTERNATIONAL SYMPOSIUM ON GALLIUM ARSENIDE AND RELATED COMPOUNDS; Karuizawa, 23-26 septembre 1985, pages 589-594, Adam Hilger Ltd, Bristol, GB; K. NAGATA et al.: "A new self-aligned structure A1GaAs/GaAs HBT for high speed digital circuits"**
• **IBM TECHNICAL DISCLOSURE BULLETIN, vol. 31, no. 5, octobre 1985, pages 149-150, New York, US; "N-type resistors in GaAs HBT technology"**

## Description

L'invention concerne un procédé de réalisation d'un circuit semiconducteur intégré incluant au fins un transistor bipolaire à hétérojonction, ce procédé comprenant pour la réalisation de ce transistor la formation sur un substrat semiconducteur de dites première, seconde et troisième couches semiconductrices de types de conductivité alternés forant des jonctions p-n dont au moins une est une hétérojonction.

L'invention concerne également la réalisation des résistances enterrées de faibles valeurs souvent nécessaires dans les circuits intégrés.

L'invention trouve son application dans la réalisation de circuits intégrés à grande vitesse et faible consommation par exemple réalisés au moyen de couches de matériau III-V sur substrat de matériau III-V ou sur substrat de silicium.

Un procédé de réalisation d'un transistor HBT non planaire est déjà connu du brevet US 4 731 340. Selon ce procédé connu, des techniques de lift-off sont utilisées pour réaliser l'auto-alignement des contacts de base sur l'émetteur. Un masque en photoresist qui définit un émetteur adjacent au contact de base est formé sur un support approprié à constituer une hétérojonction bipolaire de matériaux semiconducteurs. Un contact de base est formé par gravure à travers la couche semiconductrice supérieure jusqu'à l'hétérojonction et un métal est déposé sur la couche semiconductrice inférieure de ladite hétérojonction. Un diélectrique est alors déposé sur les contacts de base formés précédemment, puis le masque en photorésist est éliminé ce qui constitue la technique de lift-off du diélectrique et du métal dans les régions où ils sont indésirables. Le contact d'émetteur peut à ce moment être réalisé du fait que le contact de base est encore couvert par le diélectrique. Le procédé se termine par la formation d'une ouverture jusqu'à la couche la plus profonde et la réalisation du contact de collecteur sur cette couche.

Ce procédé comprend l'avantage de réaliser l'auto-alignement de la base sur la région d'émetteur, puis de réaliser le contact d'émetteur par une méthode peu critique. De plus les flancs de l'émetteur sont protégés par un diélectrique.

Mais ce procédé présente l'inconvénient de ne pas réaliser les contacts de collecteur de manière suffisamment rapprochée des contacts de base ce qui augmente les éléments parasites intrinsèques associés au transistor et notamment les capacités base-collecteur.

Or les éléments parasites diminuent considérablement la vitesse des transistors HBT. D'autre part, il est important de diminuer les dimensions des transistors HBT pour réduire leur consommation, laquelle influe aussi sur la vitesse.

C'est pourquoi un objet de la présente invention est de proposer un procédé de réalisation d'un transistor HBT dont non seulement la base et l'émetteur sont autoalignés, mais dont la distance base-collecteur est réduite, sans faire appel à des procédés de masquage sophistiqués, qui seraient coûteux ou non reproductibles.

Un autre objet de l'invention est de fournir un procédé de réalisation d'un transistor HBT dont les performances sont améliorées.

Un autre objet de l'invention est de proposer un procédé de réalisation de résistances enterrées, qui sont formées au cours des mêmes étapes de fabrication que le transistor HBT. Ce procédé mis en oeuvre conjointement à celui de la réalisation du transistor HBT permet un gain de temps dans la réalisation d'un circuit intégré incluant à la fois un tel transistor et des résistances de faibles valeurs.

Les buts de l'invention sont atteints au moyen d'un procédé tel que décrit dans la revendication 1.

L'invention sera mieux comprise au moyen de la description suivante illustrée schématiquement par les figures annexées dont :

- la figure 1a qui montre vu du dessus le transistor HBT de la figure 1b, en outre muni des interconnexions de la figure 5b ;
- la figure 1b qui montre en coupe le transistor HBT obtenu au moyen du procédé selon l'invention ;
- les figures 2a à 2o qui illustrent en coupe les différentes étapes du procédé selon l'invention dans un exemple de mise en oeuvre, pour la réalisation du transistor HBT ;
- les figures 3a à 3h qui illustrent en coupe un procédé de réalisation de résistances R de faibles valeurs pouvant être mis en oeuvre d'une manière concomitante avec le procédé de réalisation du transistor HBT réalisé dans les étapes des figures 2a à 2o ;
- la figure 4 qui montre vu du dessus la résistance R réalisée au cours des étapes illustrées par les figures 3a à 3h ;
- les figures 5a et 5b qui illustrent en coupe une méthode pour réaliser des interconnexions avec les électrodes du transistor HBT de la figure 1b ;
- la figure 6 qui montre en coupe une variante de configuration de couches propres à réaliser un transistor HBT, formées sur un substrat semiconducteur ;

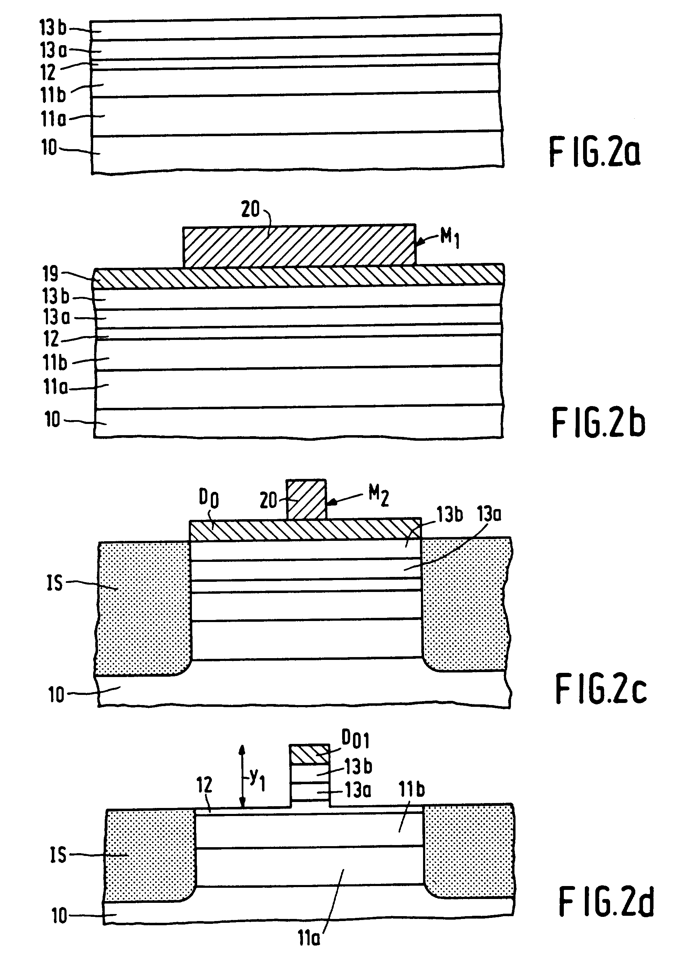

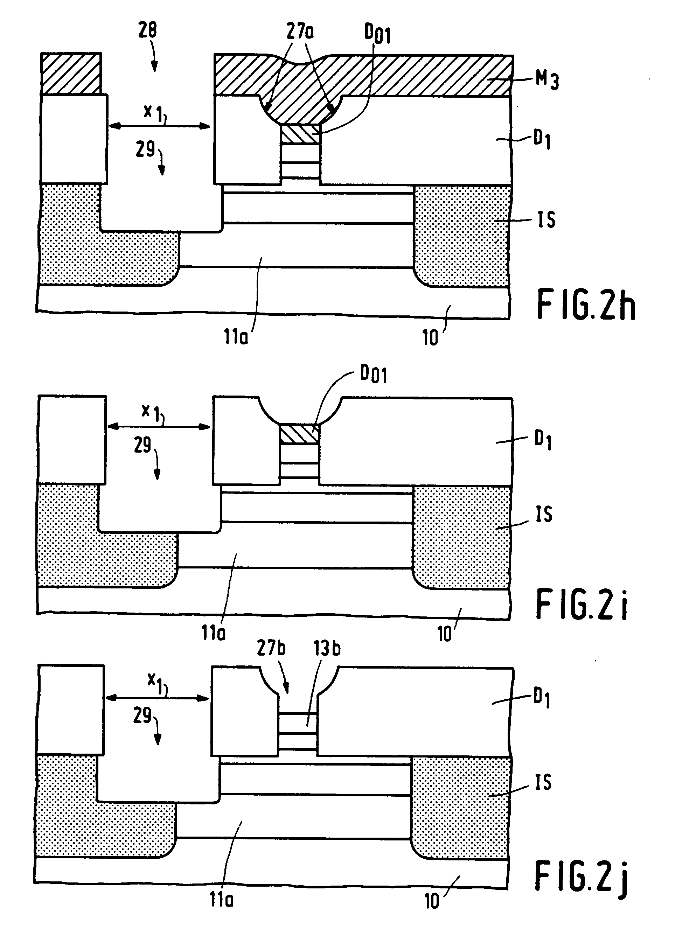

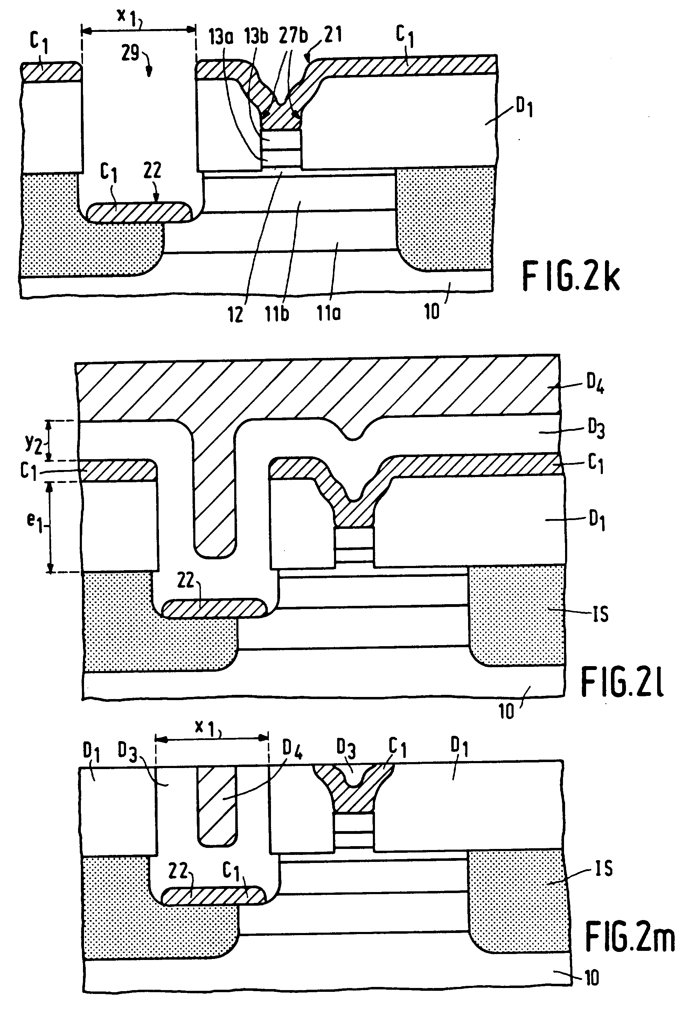

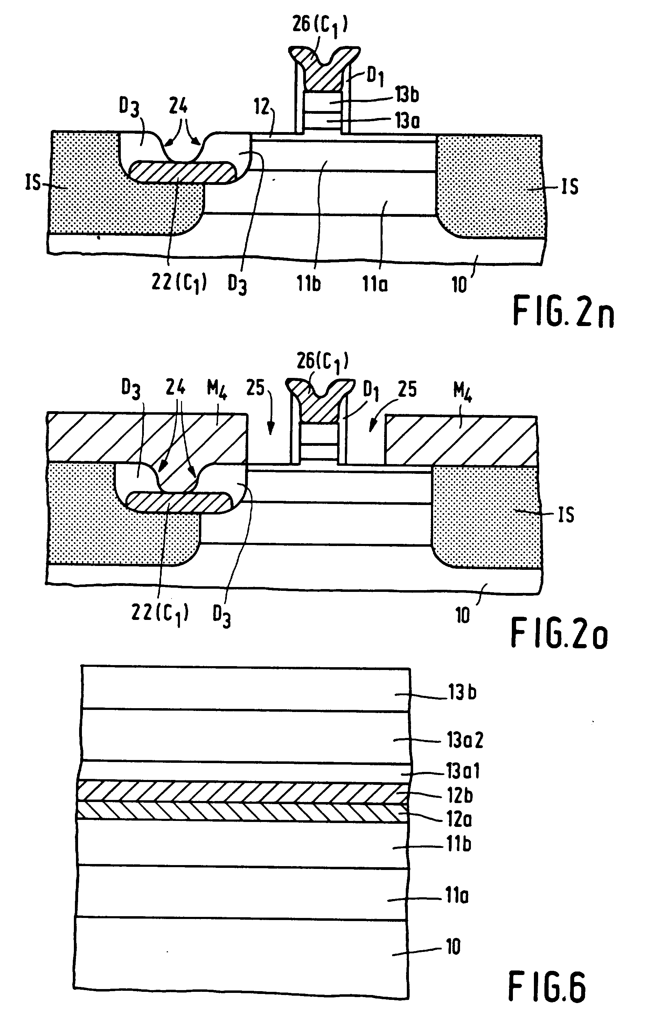

Dans un exemple de réalisation, le procédé de réalisation d'un transistor bipolaire à hétérojonction comprend les étapes suivantes, illustrées par les figures 2a à 2o qui sont des coupes selon l'axe II-II de la figure 1a, laquelle montre le transistor HBT terminé vu de dessus :

a) formation, illustrée par la figure 2a, d'un substrat 10 en un matériau semiconducteur, favorablement l'arséniure du gallium (GaAs) semi-isolant, ou le silicium (Si) muni d'une couche d'adaptation de maille cristalline.

b) formation, comme montré sur ladite figure 2a, par une méthode d'épitaxie usuelle, d'un empilement de couches de types de conductivité différents, par exemple une première couche 11 de type n, une seconde couche 12 de type p, et une troisième couche 13 de type n.

La première couche 11 de type n peut être formée de deux couches superposées 11a et 11b, respectivement de type $n^+$ dopée à $5.10^{18}$ atomes par $cm^3$ environ, et d'épaisseur $0,5\mu m$ pour la couche 11a, et de type $n^-$ dopée à $5.10^{16}$ atomes par $cm^3$ et d'épaisseur $0,5\mu m$ environ pour la couche 11b. Ces couches seront de préférence en arséniure de gallium (GaAs).

La seconde couche 12 de type p peut être formée de deux couches 12a et 12b ; la couche 12a sera de préférence en arséniure de gallium (GaAs)$p^+$ dopée à $10^{19}$ atomes par $cm^3$ et d'épaisseur $0,1\mu m$ ; la couche 12b sera de préférence en arséniure de gallium (GaAs) non dopée intentionnellement et d'épaisseur $0,01\mu m$. Cette variante est montrée en coupe sur la la figure 6.

La troisième couche 13 de type n, peut être formée de deux couches 13a et 13b, respectivement de type n pour la couche 13a dopée à $5.10^{17}$ atomes par $cm^3$ et d'épaisseur $0,2\mu m$, et de type $n^+$ pour la couche 13b dopée à $5.10^{18}$ atomes par $cm^3$ et d'épaisseur $0,2\mu m$, qui sera de préférence en arséniure de gallium (GaAs).

Les épaisseurs et dopages sont donnés à titre d'exemple. La figure 2a montre une coupe du système de couches 11, 12 et 13 plus simplifiée que sur la figure 6.

Pour former en outre une hétérostructure, la couche 13a sera de préférence en arséniure de gallium et d'aluminium (GaAlAs). A cet effet, elle peut aussi être constituée de deux couches superposées : une première couche $13a_1$ contenant une concentration d'aluminium progressive de 0 à 25% et d'épaisseur $0,03\mu m$ environ, et une seconde couche $13a_2$ contenant 25% d'aluminium et d'épaisseur environ $0,2\mu m$ (voir la figure 6).

Les couches 11, 12 et 13 peuvent être réalisées par exemple par des méthodes d'épitaxie, telles que l'épitaxie par jet moléculaire ou l'épitaxie aux organo-métalliques ou toute autre méthode connue de l'homme du métier.

c) Dépôt, illustré par la figure 2b, sur le dispositif montré sur la figure 2a, d'une couche de diélectrique 19, suivi du dépôt d'une couche de laque photosensible 20, pour réaliser masque $M_1$.

Le diélectrique 19 sera favorablement de la silice $SiO_2$, d'une épaisseur supérieure à $1\mu m$. La couche de laque 20 aura favorablement une épaisseur d'environ $1,5\mu m$.

Le masque $M_1$, formé au moyen de la couche 20 par une méthode usuelle connue de l'homme du métier est prévu pour protéger la future région active du transistor HBT pendant la formation des régions d'isolation IS comme illustré par la figure 2c. Le diélectrique 19 est alors gravé jusqu'à la surface supérieure de la couche 13 (par exemple 13b) de matériau semiconducteur, de préférence par gravure sèche, par exemple à l'aide des gaz $CHF_3$ et $SF_6$.

Le diélectrique 19 restant constitue un masque $D_0$ et est surmonté du masque $M_1$. Le dispositif ainsi constitué est ensuite soumis à l'étape suivante :

d) implantation profonde comme montré sur la figure 2c de protons ou de bore par exemple, pour constituer des régions d'isolation IS autour de la région protégée par $D_0$ et $M_1$, région qui constituera la zone active du transistor ; puis, à ce stade, le masque $M_1$ est éliminé.

e) formation comme montré sur la figure 2c d'un masque $M_2$ en surface de la couche diélectrique $D_0$, par exemple au moyen d'une laque photosensible 20' d'épaisseur environ $1\mu m$.

Le masque $M_2$ est destiné à délimiter l'émetteur 13a, 13b du transistor HBT.

Les dimensions du masque $M_2$ seront favorablement de $0,5\mu m$ à quelques $\mu m$ dans le plan de la coupe de la figure 2c (coupe selon l'axe II-II de la figure 1a), et dans la direction perpendiculaire de $1\mu m$ à plusieurs dizaines de $\mu m$.

Comme montré sur la figure 2d, le dispositif est alors soumis à une gravure autour du masque $M_2$. La couche $D_0$ est d'abord gravée par voie sèche ou humide. Puis la couche 13b en GaAs et la couche 13a en GaAlAs sont gravées par voie sèche ou humide, la gravure par voie sèche pouvant être effectuée par exemple au moyen de gaz chlorés tels que $C\ Cl_2F_2$, $SiCl_4$, $Cl_2$, $BCl_3$ et leurs dérivés en mélange avec $CH_4H_2$.

L'arrêt de la gravure se fera sur la couche 12 ou couche de base de type p, en GaAs, ou éventuellement à l'intérieur de cette couche (voir la figure 2d).

A l'issue de cette étape, si le diélectrique $D_0$ est la silice, il est éliminé par exemple à l'aide d'un bain chimique HF faiblement dilué.

Si le diélectrique $D_0$ est le nitrure de silicium, (SiN), il peut éventuellement être conservé. Le plot d'émetteur 13a, 13b, surmonté de la portion restante $D_{01}$ de la couche $D_0$ a alors une hauteur $y_1$ de l'ordre de $1,5\mu m$.

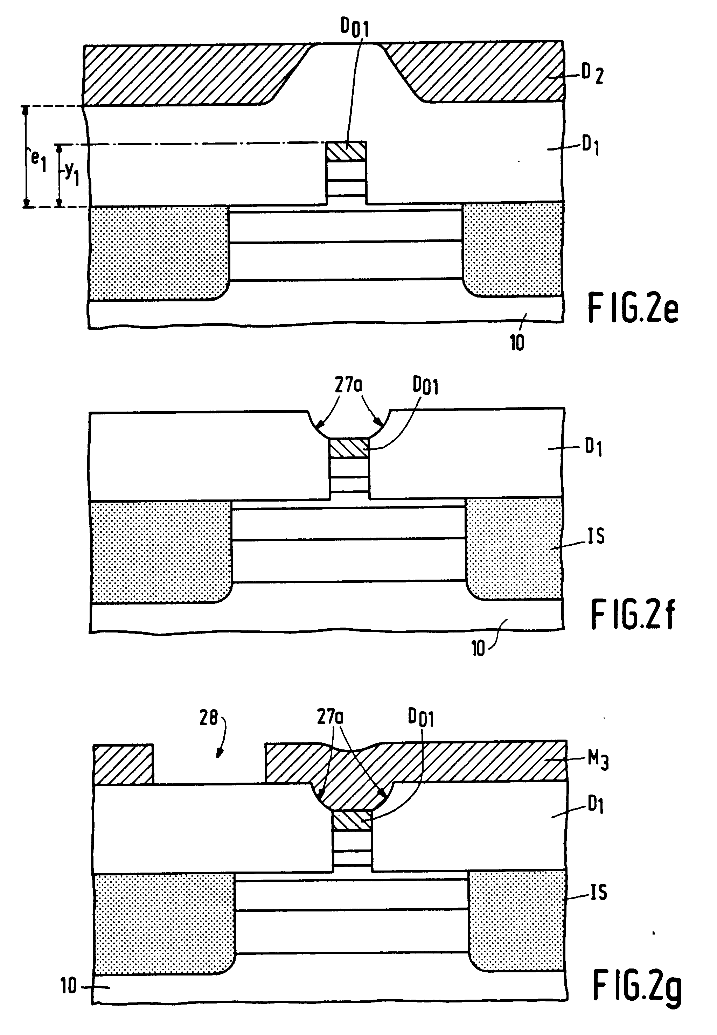

f) dépôt d'une couche de diélectrique $D_1$, comme montré sur la figure 2e, en un matériau d'un type qui se dépose en couche uniforme, par exemple la silice $SiO_2$. L'épaisseur de couche $D_1$ est donc aussi grande en surface des plots d'émetteur 21 qu'en surface de la couche 12.

Cette couche doit montrer une épaisseur $e_1$ supérieure à la hauteur $y_1$ du plot d'émetteur 21 formé à l'étape e) surmonté éventuellement du masque $D_{01}$ restant, ce qui conduit à une épaisseur minimale d'environ 600nm.

Cette épaisseur $e_1$ est particulièrement importante du fait qu'elle définira ultérieurement la distance entre la base 23 du transistor HBT et son émetteur 21. L'épaisseur $e_1$ la plus favorable pour la couche $D_1$ est environ égale à 2 fois la hauteur $y_1$ du plot d'émetteur éventuel-

lement couvert de $M_2$ :

$$e_1 = 2y_1$$

g) dépôt comme montré sur la figure 2e, d'une couche diélectrique $D_2$ d'un type qui s'étend sous forme fluide, par exemple une résine époxy ou une laque photosensible. Cette dernière ne sera pas utilisée pour ses propriétés photosensibles mais comme couche présentant des propriétés d'une part de planarisation et d'autre part de gravure différentes de celle de la couche $D_1$. De plus, elle s'étend en épaisseur plus faible sur les émetteurs qui présentent au moins une faible dimension comme on l'a dit, que sur d'autres motifs du dispositif, situés au même niveau que l'émetteur et de plus grandes dimensions. Pour servir le but du procédé, cette laque $D_2$ sera soumise à une insolation au moins 4 fois supérieure à l'énergie d'insolation dans les conditions normales d'utilisation connues de l'homme du métier pour l'utilisation en tant que masque usuel. Puis elle subira des recuits successifs de 90° à 180°C environ.

h) gravure uniforme de la couche $D_2$ comme montré sur la figure 2e jusqu'à l'apparition de la surface de la couche $D_1$ au dessus des motifs d'émetteur, par exemple par gravure RIE au moyen des gaz $SF_6$ et $CHF_3$. Puis gravure sélective des couches $D_1$ et $D_2$ simultanément avec une vitesse de gravure de la couche $D_1$ supérieure à celle de la couche $D_2$ jusqu'à l'apparition de la surface supérieure des plots d'émetteur (par exemple la surface supérieure de $D_{01}$ s'il subsiste). Cette méthode permet d'ouvrir la couche $D_1$ comme montré sur la figure 2f exclusivement sur les motifs présentant une de leur dimension faible devant les autres motifs du circuit intégré située au même niveau. Parmi les motifs présentant une faible dimension on trouve les plots d'émetteur 13a, 13b sur lesquels s'ouvre donc la couche $D_1$.

On notera qu'à l'issue de cette étape h) l'ensemble du dispositif est protégé par une couche de diélectrique $D_1$ montrant des ouvertures 27a en forme de cuvettes de faible profondeur au-dessus des motifs tels que les émetteurs, comme montré sur la figure 2f.

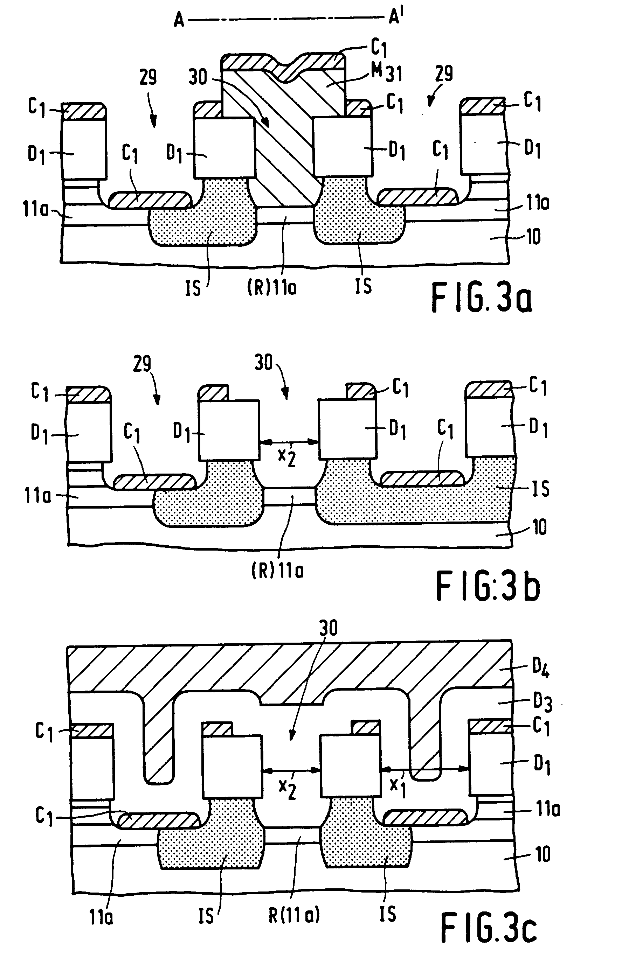

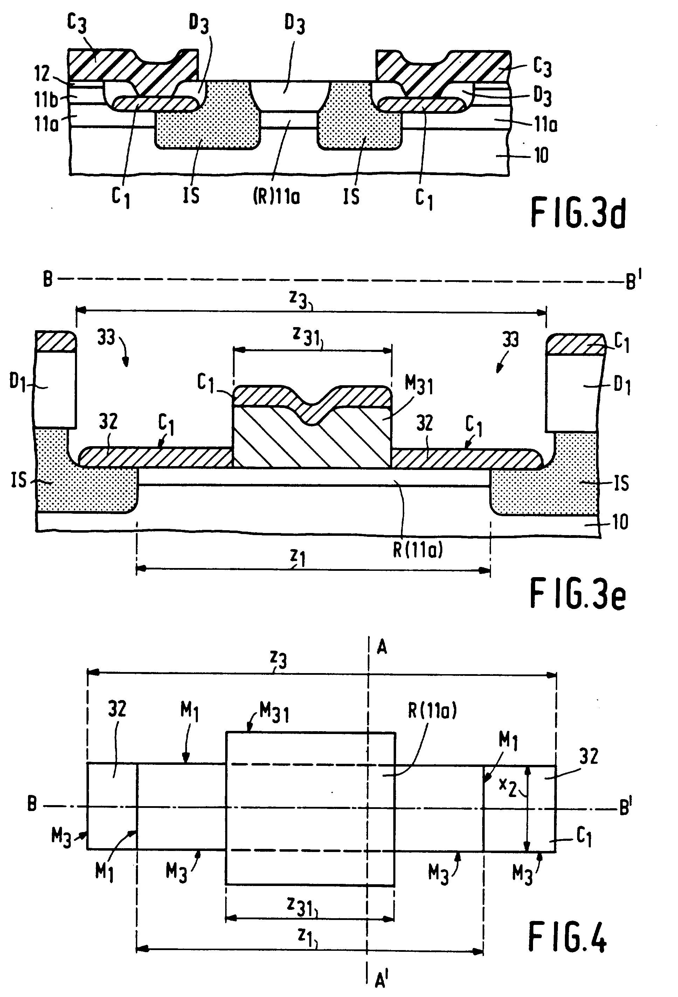

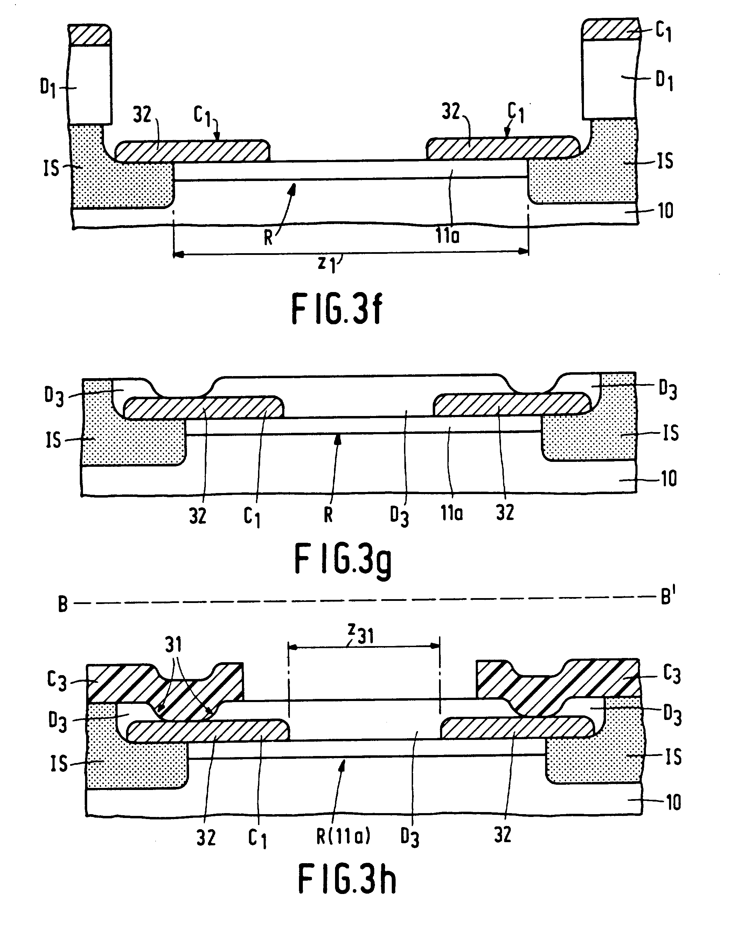

i) Réalisation, comme montré sur la figure 2g, d'un masque $M_3$ présentant une ou des ouverture(s) 28 délimitant le(s) collecteur(s) 22 du transistor HBT et éventuellement des résistances pour le circuit intégré (voir les figures 3).

j) Gravure sèche dans l'ouverture 28 du masque $M_3$ comme montré sur la figure 2h, du diélectrique $D_1$, au moyen par exemple des gaz $SF_6$ et $CHF_3$ si $D_1$ est la silice ($SiO_2$), jusqu'à la surface du matériau semiconducteur, c'est-à-dire de la couche de base 12 de type de conductivité p dans l'exemple décrit.

Puis gravure, comme montré sur la figure 2h, des couches 12 de type p et 11 (11b) de type n et arrêt de la gravure en surface de la couche lia de type $n^+$, ou à l'intérieur de cette couche (au plus de quelques 10nm). La gravure des matériaux semiconducteur 12 et 11 peut être effectuée par gravure sèche au moyen de gaz chlorés comme il a été dit précédemment, ou par gravure humide par exemple au moyen d'acide citrique en mélange avec $H_2O_2$.

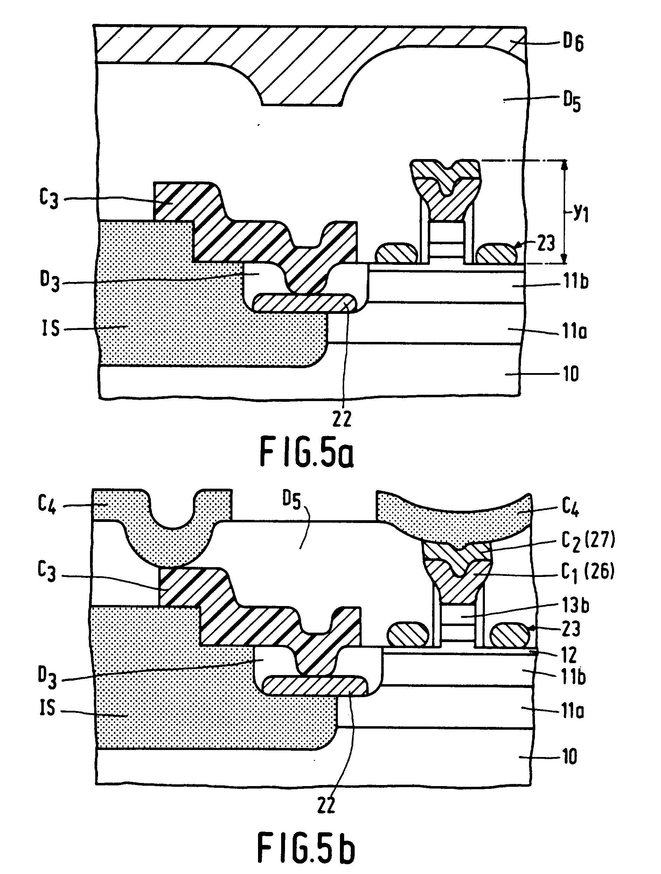

On notera que par la méthode selon l'invention, on peut réaliser, simultanément au transistor HBT, des résistances R de faibles valeurs, dites résistances enterrées. Le procédé de réalisation des résistances R est illustré par les figures 3a à 3d en coupe selon l'axe AA′ de la figure 4 et par les figures 3e à 3h en coupe selon l'axe BB′ de cette figure.

Ces résistances montrées vu du dessus sur la figure 4 sont formées au moyen de la couche 11a de type $n^+$ en GaAs comme montré sur les figures 3. Ces résistances présentent des valeurs dépendant du dopage de la couche lia de type $n^+$. On obtient typiquement par ce procédé des résistances de l'ordre $20\Omega/\square$. Pour réaliser de telles résistances comme montré sur la figure 4 vu du dessus au cours des étapes de formation du transistor HBT, comme montré sur les figure 3a à 3d, le masque $M_3$ sera judicieusement dessiné pour réaliser une ouverture 30 ultérieure (voir les figures 4, 3a à 3d) notamment il montrera dans la zone de la résistance R une ouverture qui n'excèdera pas une dimension $x_2 < x_1$ selon l'axe AA′ ; et de plus, après l'ouverture 30 des couches jusqu'à la couche 11a de type $n^+$, on protégera cette ouverture 30 au moyen d'un masque $M_{31}$ de manière à pouvoir entreprendre l'étape suivante de la réalisation du HBT. L'épaisseur de $M_{31}$ doit être grande, de l'ordre de 2 à 2,5µm, pour protéger l'emplacement de la future résistance R.

k) Elimination éventuelle du diélectrique restant $D_{01}$ comme montré sur la figure 2j, sur les plots d'émetteurs formant les ouvertures 27b, puis dépôt d'une couche $C_1$, comme montré sur la figure 2k, pour réaliser les contacts ohmiques de type n du transistor HBT sur la couche collecteur 11a et l'émetteur 21, et pour réaliser les contacts 32 d'extrémités de résistance R.

Si le diélectrique $D_{01}$ est le SiN, il sera éliminé par gravure sèche relativement douce pour ne pas perturber la couche $n^+$ (13b) qui apparaîtra en surface du plot d'émetteur 21. Le gaz $CF_4$ sera préféré (voir la figure 2j).

Les contacts ohmiques $C_1$ sont donc déposés dans les ouvertures suivantes (voir les figures 2k, 3b, 3e et 4) :

- ouvertures 29 définissant les collecteurs,
- ouvertures 33 en surface de la couche 11a de part et d'autre du masque $M_{31}$ vue selon l'axe BB′ (ou des ouvertures pour résistances). Sur la figure 3e ce dernier dépôt est destiné à former les extrémités 32 ou prises de contact desdites résistances R (sur la figure 3b, on voit des ouvertures de collecteurs 29, adjacentes à la résistance et recevant $C_1$.

- ouvertures 27b dans la couche $D_1$ au-dessus des plots d'émetteur 13a, 13b.

Le métal pour réaliser la couche $C_1$ sera favorablement déposé par évaporation sous vide ou par pulvérisation cathodique d'un alliage Au-Ge, suivie de l'évaporation ou pulvérisation d'une couche de nickel, à la suite de quoi on formera l'alliage AuGeNi à environ 400°C à 450°C.

L'épaisseur de la couche $C_1$ sera favorablement de 0,1 à 0,5µm.

$\ell$) Dépôt, comme montré sur la figure 2$\ell$, d'une couche de diélectrique $D_3$. Cette couche sera déposée aussi sur les résistances R (voir la figure 3c). A cet effet le masque $M_{31}$ sera préalablement éliminé effectuant ainsi le lift-off de $C_1$ dans cette région. Cette couche $D_3$ sera de préférence en silice ($SiO_2$) déposée par une méthode connue de l'homme du métier sous le nom de PECVD ou CVD. Cette couche a alors une épaisseur uniforme $y_2$ telle que :

$$y_2 < e_1 < x_1/2$$

où $x_1 \geq$ 3µm est la dimension transversale des ouvertures 29 ayant permis la réalisation des collecteurs 22 lorsque l'on désire réaliser un contact $C_3$ pour interconnexion du collecteur, et où $x_1$ ou $x_2 <$ 3µm dans tous les autres cas.

Le dépôt de la couche diélectrique $D_3$ est suivi comme montré sur la figure 2$\ell$, du dépôt d'une couche diélectrique $D_4$ qui sera favorablement une laque photosensible traitée comme lors de l'étape g). Cette couche sera aussi déposée sur les résistances R (voir la figure 3c).

m) Gravure, comme montré sur la figure 2m, des couches $D_3$ et $D_4$ par voie sèche à l'aide de gaz fluorés, et de façon uniforme. Les vitesses de gravure des deux diélectriques sont donc choisies identiques. La gravure est pratiquée jusqu'au niveau supérieur de la couche métallique $C_1$.

n) Usinage ionique de la couche métallique $C_1$ (voir la figure 2m). L'usinage ionique est une gravure mécanique. La couche métallique $C_1$ est retirée par cette méthode sur l'ensemble de la couche diélectrique $D_1$ à l'exception de la région d'émetteur où la couche $C_1$ est protégée par le diélectrique $D_3$ restant de l'étape précédente. On procède de même sur les résistances R.

o) Gravure des diélectriques $D_1$, $D_2$, $D_4$ par voie sèche, comme montré sur la figure 2n, on procède de même sur les résistances R.

Les diélectriques $D_1$ et $D_3$ qui sont, comme il a été dit du même matériau, de préférence la silice ($SiO_2$), doivent être gravés avec des vitesses identiques.

La vitesse de gravure du diélectrique $D_4$ devra être plus élevée que celle de $D_1$ et $D_3$, dans le but d'obtenir une ouverture 24 sur les contacts de collecteur 22 et éventuellement une ouverture 31 sur les plots 32 de prise de contact des résistances R (voir les figures 2n, 3g).

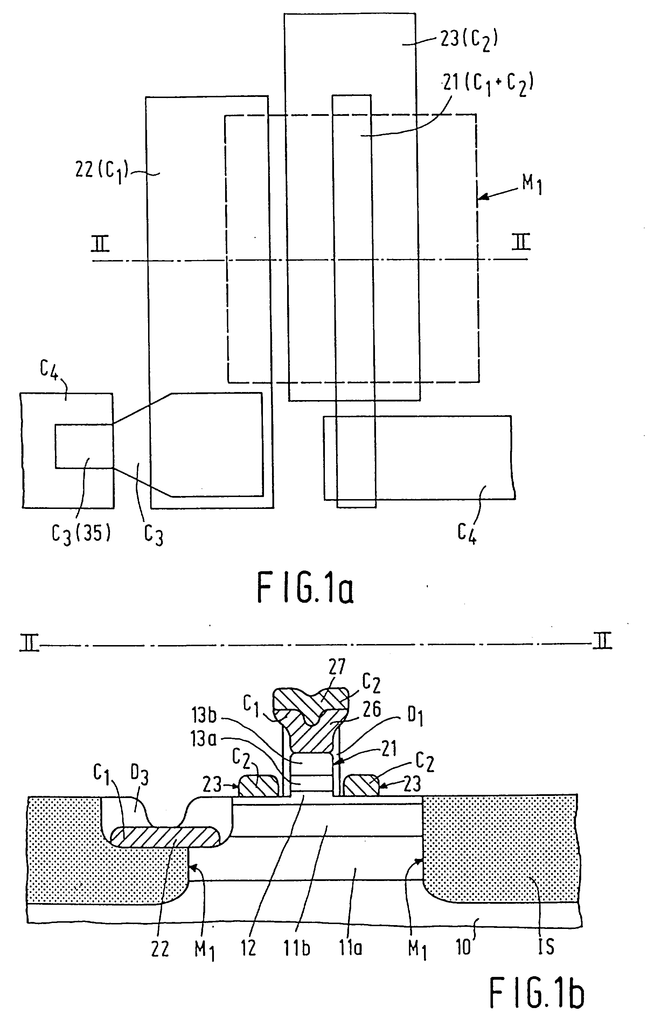

A l'issue de cette étape, il reste une protection de diélectrique $D_1$ le long des flancs du plot d'émetteur 13a, 13b. Cette protection facilitera l'autoalignement des contacts de base 23 du HBT dans l'étape suivante (voir la figure 2o et 1b).

p) Réalisation, comme montré sur la figure 2o, d'un masque $M_4$ laissant des ouvertures 25 définissant les bases 23 du HBT. Ces contacts de bases 23 sont de type p dans l'exemple décrit. Les contacts de base seront constitués, comme montré sur la figure 1b, par une couche métallique $C_1$ qui se dépose sur l'ensemble du dispositif et en particulier dans les ouvertures 25 et sur les plots d'émetteurs 26 de métal $C_1$, ajoutant une surépaisseur 27.

Le métal de la couche $C_1$ sera déposé par évaporation sous vide ou pulvérisation cathodique d'une multi-couche comprenant par exemple Ti puis Au, ou bien Ti, Pt, Au. Les épaisseurs des différents métaux n'excèdent pas 100 nm pour Ti et Pt, et environ 200nm pour Au. Un recuit permet ensuite de former le contact ohmique $C_2$. La température sera de préférence de l'ordre de 350°C, dépendant du dopage de la couche 12 de type p.

Il peut encore se poser le problème de réaliser des interconnexions avec les plots (26,27) de contacts d'émetteur, de base (23), de collecteur (22) ou d'extrémité (32) de résistance R, du fait que ces éléments ne sont pas planaires.

Les figures 5a et 5b illustrent un exemple de procédé de réalisation de telles lignes d'interconnexion sur le collecteur 22 et sur l'émetteur 26,27 du HBT. La figure 3h illustre un même exemple de procédé appliqué aux extrémités 32 de la résistance R. On réalisera d'abord des lignes $C_3$ en remontant leur niveau, le reste du dispositif étant protégé. Puis, après élimination de la couche de protection, on déposera en premier une couche $D_5$ identique à $D_1$ décrite précédemment, puis une couche $D_6$ identique à $D_2$ et l'on procédera à la gravure de ces couches de manière identique décrite précédemment ; la seconde phase de gravure (gravure de $D_5$ avec une vitesse supérieure à celle de $D_6$) étant arrêtée dès l'apparition de la surface supérieure des couches d'émetteurs 27 $C_2$ et de l'extrémité haute de la ligne $C_3$.

Pour obtenir ce résultat, l'extrémité de la ligne $C_3$ dont le niveau est supérieur au contact (22 pour le collecteur ou 32 pour l'extrémité de la résistance R) avec lequel elle assure la liaison électrique, est retrécie ou munie d'un appendice de dimension transversale équivalente à celle de l'émetteur. On pourra par exemple adopter la forme montrée sur la figure 1a vu du dessus, qui montre le rétrécissement 35 de $C_3$.

On réalise ensuite des lignes conductrices $C_4$ qui prennent contact avec $C_3$ ou avec les couches $C_2$ des émetteurs par le moyen de ces ouvertures.

Les lignes $C_3$ et $C_4$ sont réalisées par les méthodes de masquage et de dépôt de couches métalliques usuelles connues de l'homme du métier.

Le relèvement du niveau de l'extrémité des lignes $C_3$ peut être fait en formant des marches ou des pentes dans le matériau semiconducteur 10, comme montré notamment sur les figures 5a et 5b.

La connexion des contacts de base 23 peut être faite d'une manière tout à fait analogue.

## Revendications

1. Procédé de réalisation d'un circuit semiconducteur intégré incluant au moins un transistor bipolaire à hétérojonction (HBT), ce procédé comprenant pour la réalisation de ce transistor la formation sur un substrat (10) semiconducteur de dites première (11 ; 11a, 11b), seconde (12 ; 12a, 12b) et troisième (13 ; 13a, 13b) couches semiconductrices de types de conductivité alternés formant des jonctions p-n dont une au moins est une hétérojonction, caractérisé en ce qu'il comprend en outre :

a) formation de l'émetteur (21) par gravure autour d'un premier masque (D01) de la troisième couche semiconductrice (13 ; 13a, 13b) jusqu'à la seconde (12), résultant en un relief de hauteur $y_1$ ;

b) réalisation d'une première couche diélectrique ($D_1$) d'épaisseur constante, puis formation dans cette couche diélectrique ($D_1$) d'une ouverture (27a) en surface dudit premier masque (D01) de l'émetteur ;

c) gravure, à travers l'ouverture (28) d'un dit second masque ($M_3$) délimitant le collecteur (22), de cette première couche diélectrique (D1) et de la seconde couche semiconductrice (12 ; 12a, 12b) jusqu'à la première couche semiconductrice (11 ; 11a) formant pour le collecteur (22) une cavité (29) de dimension transversale $x_1$, répondant à la condition $y_1 < x_1/2$, puis élimination respectivement du second et du premier masque ($M_3$, D01) ;

d) dépôt d'une dite première couche métallique ($C_1$), servant de contact d'émetteur (21) et de contact de collecteur, (22) respectivement sur la troisième (13 ; 13b) et sur la première couche semiconductrice (11 ; 11a) ;

e) dépôt d'une dite troisième couche diélectrique ($D_3$) choisie parmi les matériaux pouvant être gravés avec la même vitesse que la première couche diélectrique ($D_1$), et ayant une épaisseur constante $y_2$ répondant à la condition

$y_1 < y_2 < x_1/2$, suivi d'un dépôt d'une première couche de planarisation ($D_4$) ayant une surface supérieure plane ;

f) planarisation par gravure d'une épaisseur constante du dispositif jusqu'au niveau supérieur de la première couche diélectrique ($D_1$) ;

g) gravure des première et troisième couches diélectriques ($D_1$, $D_3$), et de la première couche de planarisation ($D_4$), jusqu'à la seconde couche semiconductrice (12), la vitesse de gravure de la première couche de planarisation ($D_4$) étant supérieure à celle des première et troisième couches diélectriques ($D_1$ et $D_3$), les flancs du plot d'émetteur (21) et ceux de la cavité (29) du collecteur (22) restant protégés respectivement par le premier diélectrique ($D_1$) et par le troisième diélectrique ($D_3$) ;

h) dépôt, dans l'ouverture (25) d'un masque ($M_4$) définissant les bases (23) autoalignées sur l'émetteur (21), d'une dite seconde couche métallique ($C_2$) de contact de base.

2. Procédé selon la revendication 1, caractérisé en ce que pour pratiquer une ouverture (27a) dans la première couche diélectrique ($D_1$) en surface de l'émetteur (21) lors de l'étape b), cette première couche diélectrique ($D_1$) est d'abord déposée en une épaisseur constante $e_1$ sur le matériau semiconducteur et sur le plot d'émetteur de hauteur $y_1$, puis est couverte d'une seconde couche de planarisation ($D_2$) ayant une surface supérieure plane, en ce que cette seconde couche de planarisation ($D_2$) est soumise à une première phase de gravure sèche uniforme jusqu'à l'apparition de la surface de la couche du premier diélectrique ($D_1$), au-dessus des plots d'émetteur (21), puis la première couche diélectrique ($D_1$) et la seconde couche de planarisation ($D_2$) sont soumises à une seconde phase de gravure sèche, anisotrope, durant laquelle le premier diélectrique ($D_1$) est gravé avec une vitesse supérieure à celle de la seconde couche de planarisation ($D_2$), jusqu'à ce que la surface supérieure (D01) du plot d'émetteur (21) apparaisse dans une ouverture (27a) de cette première couche diélectrique ($D_1$).

3. Procédé selon l'une des revendications 1 ou 2, caractérisé en ce que pour planariser le dispositif lors de l'étape f) la troisième couche diélectrique ($D_3$) et la première couche de planarisation ($D_4$) sont gravées de manière uniforme, puis la première couche métallique de contact ($C_1$) est soumise à un usinage ionique, la partie de cette première couche de contact ($C_1$) disposée en surface du plot d'émetteur (21) étant épargnée par cet usinage ionique du fait que la précédente gravure uniforme de la troisième couche diélectrique ($D_3$) et de la première couche de planarisation ($D_4$) préserve une partie de la troisième couche diélectrique ($D_3$) en surface de la pre-

mière couche métallique ($C_1$) sur ce plot d'émetteur.

**4.** Procédé de réalisation selon l'une des revendications 1 à 3 d'un circuit semiconducteur intégré incluant à la fois un transistor bipolaire à hétérojonction (HBT) et une résistance enterrée, caractérisé en ce que, pour réaliser ces éléments de manière concomitante, la réalisation sur le substrat semiconducteur de l'empilement des couches semiconductrices (11, 12, 13) est mené à bien, suivi de la mise en oeuvre des étapes a) à h) parmi lesquelles les étapes c) et d) comprennent respectivement :

c) gravure, à travers des ouvertures respectivement pratiquées dans ledit second masque $M_3$ pour délimiter le collecteur (22) du transistor d'une part et au moins une résistance (R) d'autre part, de cette première couche diélectrique (D1) et de la seconde couche semiconductrice (12 ; 12a, 12b) jusqu'à la première couche semiconductrice (11 ; 11a) qui constitue la couche collecteur du transistor et en même temps la couche résistive de la résistance, cette étape de gravure formant pour le collecteur (22) une cavité (29) de dimension transversale $x_1$, répondant à la condition $y_1 < x_1/2$, et formant pour la résistance (R) une cavité (30, 33) ; puis élimination respectivement du second et du premier masque ($M_3$, D01) délimitant une dite région effective de résistance et deux régions d'extrémité de résistance (32) ; et dépôt d'un masque ($M_{31}$), protégeant la région effective de la résistance (R) en surface de la première couche semiconductrice (11 ; 11a) découverte par la gravure précédente ;

d) dépôt de ladite première couche métallique ($C_1$), servant également de contact pour les extrémités (32) de résistance en surface de la première couche semiconductrice (11, 11a) autour du masque ($M_{31}$) de protection de la région effective de résistance.

**5.** Procédé de réalisation d'un circuit intégré incluant à la fois un transistor bipolaire à hétérojonction et une résistance enterrée selon la revendication 4, caractérisé en ce que la dimension transversale $x_2$ de la cavité (30, 33) de résistance, formée dans l'étape c') dans la première couche diélectrique ($D_1$), est prévue telle que $x_2 < x_1$, $x_1$ étant la dimension transversale de la cavité (29) délimitant le collecteur du transistor (HBT) dans cette première couche diélectrique (D1).

**6.** Procédé selon l'une des revendications précédentes caractérisé en ce que les premier et troisième diélectriques ($D_1$ et $D_3$), sont choisis parmi la silice ($SiO_2$) et le nitrure de silicium ($Si_3N_4$), et en ce que la première couche de planarisation ($D_4$) et la seconde couche de planarisation ($D_2$), lorsqu'elle existe, sont choisies parmi les laques photosensibles et les résines polymérisables.

**7.** Procédé de réalisation selon l'une des revendications 1 à 6, caractérisé en ce que le transistor bipolaire à hétérojonction est du type n-p-n, l'hétérojonction se situant au niveau de la jonction p-n supérieure, et en ce que les contacts sont du type ohmique respectif des couches sur lesquelles ils sont réalisés.

**8.** Procédé de réalisation selon l'une des revendications précédentes, caractérisé en ce qu'il comprend une étape pour réaliser pour chaque dispositif, transistor (HBT) ou résistance respectivement, une délimitation de sa zone active ou utile par des régions isolantes, formées par une méthode choisie parmi l'implantation de bore ou l'implantation de protons.

**9.** Procédé selon l'une des revendications précédentes caractérisé en ce que le substrat (10) est choisi parmi l'arséniure de gallium semi-isolant ou le silicium muni d'une couche d'arséniure de gallium semi-isolant, et en ce que les première, seconde, et troisième couches semiconductrices sont formées comme suit :
la première couche semiconductrice (11) est formée de deux sous-couches :

- une couche (11a) de type $n^+$ dopée à environ $5.10^{18}$ atomes par $cm^3$ d'épaisseur environ 0,5 $\mu m$, en arséniure de gallium,
- une couche (11b) de type $n^-$ dopée à environ $5.10^{16}$ atomes par $cm^3$ d'épaisseur environ 0,5 $\mu m$, en arséniure de gallium ; la seconde couche semiconductrice (12) est formée de deux sous-couches :
- une couche (12a) de type $p^+$ dopée à environ $10^{19}$ atomes par $cm^3$ d'épaisseur environ 0,1 $\mu m$, en arséniure de gallium,
- une couche (12b) non dopée intentionnellement, d'épaisseur environ 0,01 $\mu m$, en arséniure de gallium ;

la troisième couche semiconductrice (13) est formée de trois sous-couches :

- une couche (13a1) de type n dopée à environ $5.10^{17}$ atomes par $cm^3$ et d'épaisseur environ 0,03 $\mu m$, en arséniure de gallium et d'aluminium, dont la concentration en aluminium est progressive de 0 à 25 %,
- une couche (13a2) de type n dopée à environ $5.10^{17}$ atomes par $cm^3$, d'épaisseur environ 0,2 $\mu m$, en arséniure de gallium et d'aluminium dont la concentration en aluminium est de l'ordre de 25 %,

- une couche (13b) de type $n^+$ dopée à environ $5.10^{18}$ atomes par $cm^3$ et d'épaisseur environ $0,2\ \mu m$, en arséniure de gallium.

## Patentansprüche

1. Ein Verfahren zur Herstellung einer halbleiterintegrierten Schaltung umfassend mindestens einen Heteroübergang-Bipolartransistor (HBT), das Verfahren umfaßt für die Herstellung dieses Transistors die Bildung eines Halbleitersubstrats (10) sogenannter erster (11; 11a, 11b), zweiter (12; 12a, 12b) und dritter (13; 13a, 13b) halbleitender Schichten vom Typ wechselnder Leitfähigkeit, die die Übergänge p-n bilden, von denen mindestens einer ein Heteroübergang ist, mit dem Merkmal, daß es zusätzlich aus folgendem Besteht :

     a) Bildung des Emitters (21) durch Gravur um eine erste Maske (D01) der dritten Halbleiterschicht (13; 13a, 13b) bis zur zweiten (12), was ein Relief der Höhe $y_1$ ergibt;

     b) Bildung einer ersten Nichtleiterschicht ($D_1$) konstanter Stärke, dann Bildung einer Öffnung (27a) in dieser Nichtleiterschicht ($D_1$) an der Oberfläche der besagten ersten Maske (D01) des Emitters;

     c) Gravur durch die Öffnung (28) einer besagten zweiten Maske ($M_3$) zur Begrenzung des Kollektors (22) durch diese erste Nichtleiterschicht ($D_1$) und die zweite Halbleiterschicht (12; 12a, 12b) bis zur ersten Halbleiterschicht (11; 11a) zur Bildung einer Aushöhlung (29) der Querabmessung $x_1$ für den Kollektor (22), entsprechend der Bedingung $y_1 < x_1/2$, dann Entfernung der jeweiligen zweiten und ersten Maske ($M_3$, D01)

     d) Aufbringung einer besagten ersten Metallschicht ($C_1$), die als Emitterkontakt (21) und Kollektorkontakt (22) dient, auf die dritte (13; 13b) und auf die erste Halbleiterschicht (11; 11a) ;

     e) Aufbringung einer besagten dritten, unter den Materialien ausgewählten Nichtleiterschicht ($D_3$), die mit derselben Geschwindigkeit wie die erste Nichtleiterschicht ($D_1$) graviert werden können und eine konstante, der Bedingung $y_1 < y_2 < x_1/2$ entsprechende Stärke $y_2$ aufweisen, gefolgt von der Aufbringung einer ersten Ebnungsschicht ($D_4$) mit einer größeren, ebenen Oberfläche;

     f) Ebnung durch Gravur einer konstanten Stärke der Vorrichtung bis auf das oberste Niveau der ersten Nichtleiterschicht ($D_1$);

     g) Gravur der ersten und dritten Nichtleiterschicht ($D_1$, $D_3$) und der ersten Ebnungsschicht ($D_4$) bis zur zweiten Halbleiterschicht (12), wobei die Gravurgeschwindigkeit der ersten Ebnungsschicht ($D_4$) über der der ersten und dritten Nichtleiterschichten ($d_1$ und $D_3$) liegt, wobei die Seiten des Emitterkontakts (21) und die der Aushöhlung (29) des Kollektors (22) weiterhin von jeweils dem ersten Nichtleiter ($D_1$) und dem dritten Nichtleiter ($D_3$) geschützt bleiben;

     h) Einbringung einer sogenannten zweiten Basiskontakt-Metallschicht ($C_2$) in die Öffnung (25) einer Maske ($M_4$) zur Eingrenzung der auf den Emitter (21) selbstausrichtenden Basen (23).

2. Ein Verfahren laut Anspruch 1, mit dem Merkmal, daß für die Erstellung einer Öffnung (27a) in der ersten Nichtleiterschicht ($D_1$) an der Oberfläche des Emitters (21) bei Schritt b), diese erste Nichtleiterschicht ($D_1$) zuerst mit konstanter Stärke $e_1$ auf das Halbleitermaterial und den Emitterkontakt der Höhe $y_1$ aufgebracht wird und dann mit einer zweiten Ebnungsschicht ($D_2$) bedeckt wird, die eine ebene oberste Fläche aufweist, daß diese zweite Ebnungsschicht ($D_2$) einer ersten einheitlichen trockenen Gravurphase bis zum Erscheinen der Oberfläche der ersten Nichtleiterschicht ($D_1$) über den Emitterkontakten (21) unterworfen wird und dann die erste Nichtleiterschicht ($D_1$) und die zweite Ebnungsschicht ($D_2$) einer zweiten trockenen, anisotropischen Gravurphase unterworfen wird, während der erste Nichtleiter ($D_1$) mit einer schnelleren Geschwindigkeit als die zweite Ebnungsphase ($D_2$) graviert wird, bis die obere Oberfläche (D01) des Emitterkontakts (21) in der Öffnung (27a) dieser ersten Nichtleiterschicht ($D_1$) erscheint.

3. Ein Verfahren laut einer der Ansprüche 1 oder 2, mit dem Merkmal, daß für die Ebnung der Vorrichtung bei Schritt f) die dritte Nichtleiterschicht ($D_3$) und die erste Ebnungsschicht ($D_4$) gleichförmig graviert werden, und dann die erste Metallkontaktschicht ($C_1$) ionisch bearbeitet wird, dieser Teil der ersten, auf die Oberfläche des Emitterkontakts (21) aufgebrachte Kontaktschicht ($C_1$) wird aufgrund der Tatsache nicht ionisch bearbeitet, da die vorhergehende, gleichförmige Gravur der dritten Nichtleiterschicht ($D_3$) und der ersten Ebnungsschicht ($D_4$) einen Teil der dritten Nichtleiterschicht ($D_3$) auf der Oberfläche der ersten Metallschicht ($C_1$) auf diesem Emitterkontakt erhält.

4. Ein Verfahren zur Herstellung laut einem der Ansprüche 1 bis 3 einer halbleiterintegrierten Schaltung umfassend zugleich einen Heteroübergang-Bipolartransistor (HBT) und einen vergrabenen Widerstand, mit dem Merkmal, daß zur gleichzeitigen Herstellung dieser Elemente die Erstellung von Mehrfach-Halbleiterschichten (11, 12, 13) auf dem Halbleitersubstrat vorgenommen und dann zu den Schritten a) bis h) übergegangen wird, von denen die Schritte c) und d) jeweils aus folgendem Bestehen :

c) Gravur durch die jeweiligen gefertigten Öffnungen in der besagten zweiten Maske $M_3$ zur Begrenzung des Kollektors (22) einerseits des Transistors und andererseits mindestens eines Widerstands (R) dieser ersten Nichtleiterschicht ($D_1$) und der zweiten Halbleiterschicht (12; 12a, 12b) bis zur ersten Halbleiterschicht (11; 11a), die die Kollektorschicht des Transistors und zugleich die spezifische Widerstandsschicht des Widerstands bildet, bei diesem Gravurschritt wird für den Kollektor (22) eine Aushöhlung (29) der Querabmessung $x_1$ gebildet, die der Bedingung $y_1 < x_1/2$ entspricht und für den Widerstand (R) eine Aushöhlung (30, 33) bildet; daraufhin Entfernung jeweils der zweiten und der ersten Maske ($M_3$, D01) zur Begrenzung eines besagten Wirkbereichs des Widerstands und zweier Bereiche an den äußeren Enden des Widerstands (32); und

Aufbringung einer Maske ($M_{31}$) zum Schutz des Wirkbereichs des Widerstands (R) auf der Oberfläche der zweiten Halbleiterschicht (11; 11a), freigelegt durch die vorhergehende Gravur;

d) Aufbringung der besagten ersten Metallschicht ($C_1$), die auf der Oberfläche der ersten Halbleiterschicht (11, 11a) um die Schutzmaske ($M_{31}$) um den Wirkbereich des Widerstands zugleich als Kontakt für die beiden äußeren Enden (32) des Widerstands dient.

5. Ein Verfahren zur Herstellung einer halbleiterintegrierten Schaltung umfassend zugleich einen Heteroübergang-Bipolartransistor und einen vergrabenen Widerstand laut Anspruch 4, mit dem Merkmal, daß die Querabmessung $x_2$ der Aushöhlung (30, 33) des Widerstands, die bei Schritt c) in der ersten Nichtleiterschicht ($D_1$) geformt wurde, entsprechend $x_2 < x_1$ vorgesehen wird, wobei $x_1$ die Querabmessung der Aushöhlung (29) ist, die den Kollektor des Transistors (HBT) in dieser ersten Nichtleiterschicht ($D_1$) begrenzt.

6. Ein Verfahren laut einem der vorherigen Ansprüche, mit dem Merkmal, daß für die ersten und dritten Nichtleiter ($D_1$ und $D_3$) Kieselerde ($SiO_2$) oder Siliziumnitrid ($Si_3N_4$) gewählt wird, und daß für die erste Ebnungsschicht ($D_4$) und die zweite Ebnungsschicht ($D_2$), wenn sie besteht, Fotolack oder polymerisierbare Harze gewählt werden.

7. Ein Verfahren laut einem der Ansprüche 1 bis 6, mit dem Merkmal, daß der Heteroübergang-Bipolartransistor von Typ n-p-n ist, wobei sich der Heteroübergang auf dem Niveau des oberen Übergangs p-n befindet, und, daß die Kontakte der jeweiligen Schichten, auf denen sie hergestellt wurden, ohmschen Typs sind.

8. Ein Herstellungsverfahren laut einem der vorgenannten Ansprüche, mit dem Merkmal, daß es einen Schritt für die jeweilige Herstellung jeder Vorkehrung, Transistor (HBT) oder Widerstand, eine Begrenzung der Aktiv- oder Nutzbereiche durch Isolierbereiche aufweist, die durch Auswahl eines Verfahren gebildet werden, die aus der auf der Einbringung von Bor oder der Einbringung von Protonen beruht.

9. Ein Verfahren laut einem der vorgenannten Ansprüche, mit dem Merkmal, daß für das Substrat (10) semi-isolierendes Galliumarsenid oder mit einer semi-isolierenden Schicht Galliumarsenid versehenes Silizium gewählt wird, und, daß die ersten, zweiten und dritten Halbleiterschichten wie folgt gebildet werden :

Die erste Halbleiterschicht (11) wird aus zwei Unterschichten gebildet :

- einer Schicht (11a) vom Typ $n^+$, dotiert mit ca. $5.10^{18}$ Atomen pro $cm^3$ einer Stärke von ca. 0,5 μm aus Galliumarsenid,
- einer Schicht (11b) vom Typ $n^-$, dotiert mit ca. $5.10^{16}$ Atomen pro $cm^3$ einer Stärke von ca. 0,5 μm aus Galliumarsenid;

die zweite Halbleiterschicht (12) wird aus zwei Unterschichten gebildet :

- einer Schicht (12a) vom Typ $p^+$, dotiert mit ca. $10^{19}$ Atomen pro $cm^3$ einer Stärke von ca. 0,1 μm aus Galliumarsenid,
- einer Schicht (12b), absichtlich nicht dotiert, mit und einer Stärke von ca. 0,01 μm aus Galliumarsenid;

die dritte Halbleiterschicht (13) wird aus drei Unterschichten gebildet :

- einer Schicht (13a1) vom Typ n, dotiert mit ca. $5.10^{17}$ Atomen pro $cm^3$ einer Stärke von ca. 0,03 μm aus Galliumarsenid und Aluminium mit einer steigenden Aluminiumkonzentration von 0 auf 25%,
- einer Schicht (13a2) vom Typ n, dotiert mit ca. $5.10^{17}$ Atomen pro $cm^3$ einer Stärke von ca. 0,2 μm aus Galliumarsenid und Aluminium und einer Aluminiumkonzentration der Größenordnung von 25%,
- einer Schicht (13b) vom Typ $n^+$, dotiert mit ca. $5.10^{18}$ Atomen pro $cm^3$ einer Stärke von ca. 0,2 μm aus Galliumarsenid.

## Claims

1. A method of manufacturing an integrated semiconductor circuit including at least one bipolar heterojunction transistor (HBT), which method comprises for the manufacture of this transistor the step of forming on a semiconductor substrate (10) first (11; 11a, 11b), second (12; 12a, 12b) and third (13; 13a, 13b) semiconductor layers of alternate conductivity types forming pn junctions, at least one of which is a heterojunction, characterized in that it comprises in addition the following steps:

a) forming the emitter (21) by etching the third semiconductor layer (13; 13a, 13b) around a first mask (D01) down to the second semiconductor layer (12), which results in a relief having a height $y_1$;

b) forming a first dielectric layer ($D_1$) of constant thickness, then providing an opening (27a) at the surface of said first emitter mask (D01) in this dielectric layer ($D_1$);

c) etching, through the opening (28) of a second mask ($M_3$) defining the collector (22), this first dielectric layer ($D_1$) and the second semiconductor layer (12; 12a, 12b) down to the first semiconductor layer (11; 11a, 11b), forming for the collector (22) a cavity (29) having a transverse dimension $x_1$ which satisfies the condition $y_1 < x_1/2$, and then eliminating the first and second masks ($M_3$, D01, respectively);

d) depositing a first metal layer ($C_1$) for contacting the emitter (21) and collector (22) on the third (13; 13b) and on the first (11; 11a) semiconductor layers, respectively;

e) depositing a third dielectric layer ($D_3$) chosen from among the materials which can be etched at the same rate as the first dielectric layer ($D_1$) and having a constant thickness $y_2$ which satisfies the condition $y_1 < y_2 < x_1/2$, and then depositing a first planarization layer ($D_4$) having a plane upper surface;

f) planarizing the device down to the upper level of the first dielectric layer ($D_1$) through etching away of a constant thickness;

g) etching the first and third dielectric layers ($D_1$, $D_3$) and the first planarization layer ($D_4$) down to the second semiconductor layer (12), the etching rate of the first planarization layer ($D_4$) being higher than that of the first and third dielectric layers ($D_1$ and $D_3$), while the flanks of the emitter pad (21) and those of the cavity (29) of the collector (22) remain protected by the first dielectric ($D_1$) and the third dielectric ($D_3$), respectively;

h) depositing a second metal layer ($C_2$) for the base contact in the opening (25) of a mask ($M_4$) defining the bases (23) self-aligned on the emitter (21).

2. A method as claimed in Claim 1, characterized in that for providing an opening (27a) in the first dielectric layer ($D_1$) at the surface of the emitter (21) during step b), this first dielectric layer ($D_1$) is first deposited to a uniform thickness $e_1$ on the semiconductor material and on the emitter pad of thickness $y_1$, is then covered by a second planarization layer ($D_2$) having a plane upper surface, in that this second planarization layer ($D_2$) is subjected to a first uniform dry etching step until the surface of the layer of the first dielectric ($D_1$) appears above the emitter pads (21), after which the first dielectric layer ($D_1$) and the second planarization layer ($D_2$) are subjected to a second, anisotropic dry etching step during which the first dielectric ($D_1$) is etched at a rate higher than that of the second planarization layer ($D_2$) until the upper surface (D01) of the emitter pad (21) appears in an opening (27a) of this first dielectric layer ($D_1$).

3. A method as claimed in any one of Claims 1 and 2, characterized in that, in order to planarize the device during the step f), the third dielectric layer ($D_3$) and the first planarization layer ($D_4$) are uniformly etched, after which the first metal contact layer ($C_1$) is subjected to an ion machining step, the portion of said first contact layer ($C_1$) disposed at the surface of the emitter pad (21) being unaffected by this ion machining step due to the fact that the preceding uniform etching step of the third dielectric layer ($D_3$) and the first planarization layer ($D_4$) preserves a portion of the third dielectric layer ($D_3$) at the surface of the first metal layer ($C_1$) on this emitter pad.

4. A method of manufacturing an integrated semiconductor circuit as claimed in any one of the Claims 1 to 3, which circuit includes a bipolar heterojunction transistor (HBT) as well as a buried resistor, characterized in that, in order to manufacture the elements in a coordinated manner, the realisation on the semiconductor substrate of the stack of semiconductor layers (11, 12, 13) is completed, followed by carrying out of the steps a) to h), among which the steps c) and d) comprise respectively:

c) etching said first dielectric layer ($D_1$) and the second semiconductor layer (12; 12a, 12b) down to the first semiconductor layer (11; 11a) which forms the collector layer of the transistor and at the same time the resistive layer of the resistor through respective openings provided in the second mask ($M_3$) for defining the collector (22) of the transistor on the one hand and at least one resistor (R) on the other hand, which etching step forms a cavity (29) having a transverse dimension $x_1$ for the collector (22) satisfying the condition $y_1 < x_1/2$, and forms a cavity (30, 33) for the resistor (R); then eliminating the second and the first mask ($M_3$, D01, respectively) which define an effective resistor region and two end regions of the resistor (32); and

depositing a mask ($M_{31}$) protecting the effective region of the resistor (R) at the surface of the first semiconductor layer (11; 11a) uncovered by the preceding etching step;

d) depositing the first metal layer ($C_1$) which serves also as a contact for the resistor ends (32) at the surface of the first semiconductor layer (11; 11a) around the mask ($M_{31}$) which protects the effective resistor region.

5. A method of manufacturing an integrated circuit which includes a bipolar heterojunction transistor as well as a buried resistor as claimed in Claim 4, characterized in that the transverse dimension $x_2$ of the resistor cavity (30, 33) formed in the first dielectric layer ($D_1$) during step c' is provided such that $x_2 < x_1$, $x_1$ being the transverse dimension of the cavity (29) defining the collector of the transistor (HBT) in this first dielectric layer ($D_1$).

6. A method as claimed in any one of the preceding Claims, characterized in that the first and third dielectrics ($D_1$, $D_3$) are chosen from silica ($SiO_2$) and silicon nitride ($Si_3N_4$), and in that the first planarization layer ($D_4$) and the second planarization layer ($D_2$), if the latter is present, are chosen from among photoresists and resins capable of polymerization.

7. A manufacturing method as claimed in any one of the Claims 1 to 6, characterized in that the bipolar heterojunction transistor is of the npn type, the heterojunction being situated at the level of the upper pn junction, and in that the contacts are of the ohmic type relative to the layers on which they are realised.

8. A manufacturing method as claimed in any one of the preceding Claims, characterized in that it comprises a step for realising a delimitation of the active or useful zone for each device, transistor (HBT) or resistor, as applicable, by means of insulating regions formed by a method chosen from boron implantation and proton implantation.

9. A method as claimed in any one of the preceding Claims, characterized in that the substrate (10) is chosen from semi-insulating gallium arsenide and silicon provided with a semi-insulating gallium arsenide layer, and in that the first, second, and third semiconductor layers are formed as follows:

the first semiconductor layer (11) is formed by two sub-layers:

- an $n^+$-type layer (11a) doped with approximately $5.10^{18}$ atoms/cm$^3$ and having a thickness of approximately 0.5 μm, made of gallium arsenide, and

- an $n^-$-type layer (11b) doped with approximately $5.10^{16}$ atoms/cm$^3$ and having a thickness of approximately 0.5 μm, made of gallium arsenide;

the second semiconductor layer (12) is formed by two sub-layers:

- a $p^+$-type layer (12a) doped with approximately $10^{19}$ atoms/cm$^3$ and having a thickness of approximately 0.1 μm, made of gallium arsenide, and

- a layer (12b) which is not intentionally doped and has a thickness of approximately 0.01 μm, made of gallium arsenide;

the third semiconductor layer (13) is formed by three sub-layers:

- an n-type layer (13a1) doped with approximately $5.10^{17}$ atoms/cm$^3$ and having a thickness of approximately 0.03 μm, made of gallium-aluminium arsenide in which the aluminium concentration changes progressively from 0 to 25 %,

- an n-type layer (13a2) doped with approximately $5.10^{17}$ atoms/cm$^3$ and having a thickness of approximately 0.2 μm, made of gallium-aluminium arsenide in which the aluminium concentration is of the order of 25 %, and

- an $n^+$-type layer (13b) doped with approximately $5.10^{18}$ atoms/cm$^3$ and having a thickness of approximately 0.2 μm, made of gallium arsenide.

$23(C_2)$

$21(C_1 \cdot C_2)$

$22(C_1)$

$M_1$

II — II

$C_4$

$C_3(35)$     $C_3$

$C_4$

## FIG.1a

II — II

27     $C_2$

$C_1$     26     $D_1$

13b

13a     21

$C_2$     $C_2$

$C_1$     $D_3$     23     23

22     $M_1$     12     11b     11a     $M_1$     10     IS

## FIG.1b

12

13b
13a
12
11b
11a
10

**FIG.2a**

20
M₁
19
13b
13a
12
11b
11a
10

**FIG.2b**

D₀
20
M₂
13b 13a
IS
10

**FIG.2c**

D₀1
13b
13a
12
y₁
11b
IS
10
11a

**FIG.2d**

FIG.2e

FIG.2f

FIG.2g

FIG.2h

FIG.2i

FIG.2j

FIG.2k

FIG.2l

FIG.2m

16

FIG.2n

FIG.2o

FIG.6

FIG.3a

FIG:3b

FIG.3c

FIG.3d

FIG.3e

FIG.4

FIG.3f

FIG.3g

FIG.3h

FIG.5a

FIG.5b